Europäisches Patentamt

European Patent Office

Office européen des brevets

(11) Publication number: **0 112 657**
**B1**

(12) **EUROPEAN PATENT SPECIFICATION**

(45) Date of publication of patent specification: **20.06.90**

(21) Application number: **83307213.5**

(22) Date of filing: **25.11.83**

(51) Int. Cl.⁵: **H 01 L 29/10, H 01 L 29/80,**
**H 01 L 21/265, H 01 L 21/318**

(54) Field effect transistor and process for fabricating it.

(30) Priority: **29.11.82 JP 209078/82**
**01.04.83 JP 57242/83**

(43) Date of publication of application:
**04.07.84 Bulletin 84/27**

(45) Publication of the grant of the patent:
**20.06.90 Bulletin 90/25**

(84) Designated Contracting States:
**DE FR GB**

(56) References cited:
**US-A-4 163 984**

**ELECTRONICS LETTERS, vol. 13, no. 7, 31st March 1977, pages 187,188, London, GB; J. KUNG et al: "GaAs F.E.T.S. with silicon-implanted channels"**

**INTERNATIONAL ELECTRON DEVICES MEETING, Washington, US, 7th-9th December 1981, IEEE, New York, US; N. YOKOYAMA et al.: "Ti/W silicide gate technology for self-aligned GaAs MESFET VLSIS"**

(73) Proprietor: **FUJITSU LIMITED**
**1015, Kamikodanaka Nakahara-ku**
**Kawasaki-shi Kanagawa 211 (JP)**

(72) Inventor: **Kawata, Haruo**
**Choko-Haitsu 202 1540-8, Hase**
**Atsugi-shi Kanagawa 243 (JP)**
Inventor: **Nishi, Hidetoshi**
**1-22-10, Chuorinkan**
**Yamato-shi Kanagawa 242 (JP)**
Inventor: **Onodera, Hiroyuki**
**Kopo-Kawajin 105, 1212, Sanda**
**Atsugi-shi Kanagawa 243-02 (JP)**
Inventor: **Yokoyama, Naoki**
**Riba-Haitsu 326, 2557-1, Tsumada**
**Atsugi-shi Kanagawa 243 (JP)**

(74) Representative: **Rackham, Stephen Neil et al**
**GILL JENNINGS & EVERY 53-64 Chancery Lane**
**London WC2A 1HN (GB)**

(56) References cited:
**SOLID-STATE TECHNOLOGY, vol. 19, no. 11, November 1976, pages 31-38, Port Washington, New York, US; J. SANSBURY: "Applications of ion implantation in semiconductor processing"**

Courier Press, Leamington Spa, England.

(56) References cited:

PATENTS ABSTRACTS OF JAPAN, vol. 7, no.
258 (E-211)1403r, 17th November 1983; & JP - A
- 58 143 576 (TOKYO SHIBAURA DENKI K.K.)
26-08-1983

IEEE JOURNAL OF SOLID-STATE CIRCUITS, vol.
SC-16, no. 6, December 1981, pages 648-652,
IEEE, New York, US; J.A. ARCHER et al.: "A
GaAs monolithic low-noise broad-band
amplifier"

APPLIED PHYSICS LETTERS, vol. 40, no. 8, 15th
April 1982, pages 589,590, American Institute of
Physics, New York, US; S. OKAMURA et al.:
"AlN capped annealing of Si implanted semi-
insulating GaAs"

International Electron Devices Meeting,
December 1-5, 1979, pages 493-496

## Description

This invention relates to a process for fabricating a compound semiconductor FET with a high transconductance.

Gallium arsenide (GaAs) integrated circuits (IC's) show promise as high speed devices for telecommunications and computers, as an alternative to silicon (Si) large scale integrated circuits (LSI's) and are, therefore, under vigorous investigation. For example, recently GaAs LSI's such as a 16×16-bit multiplier and a 1k-bit static random access memory have been successfully fabricated. In order to improve the output-current-drive capability and the degree of integration of the GaAs LSI's, it is necessary to decrease the size of an element of a GaAs LSI, and to increase the transconductance $g_m$ of a GaAs FET.

The $g_m$ of an FET is expressed by the following formula:

$$g_m = \frac{\varepsilon \mu W_g}{dL_g}(V_{gs} - V_{th})$$

wherein $\varepsilon$ is the dielectric constant of the GaAs, $\mu$ the carrier mobility, $W_g$ the gate width, $d$ the effective channel layer thickness, $L_g$ the gate length, $V_{gs}$ the voltage applied between the gate and source electrodes, and $V_{th}$ the threshold voltage. The $g_m$ per unit gate width with a fixed $V_{th}$ can be increased by shortening $L_g$, increasing $\mu$, or reducing $d$, at a constant $\varepsilon$. The common way to decrease the device size and the gate capacitance is to shorten the gate length. Although most conventional semiconductors are of silicon, compound semiconductors such as GaAs are now under investigation, since they have a larger $\mu$ than that of silicon. The present invention is directed at reducing $d$, i.e. reducing the effective channel layer thickness.

Recently, the channel layer of an FET of a compound semiconductor LSI, and as a GaAs LSI, has in general, been formed by an ion implantation technique. The depth distribution of the concentration of implanted ions in the channel layer becomes approximately the Gaussian distribution given in the Lindhard, Scharf, and Schiott theory, and the effective channel layer thickness $d$ can be considered to be approximately $(R_p + \sigma\sqrt{8/\pi})$, wherein $R_p$ is the mean projected range and $\sigma$ the standard deviation of the projected range. When the kinds of the material of the compound semiconductor substrate to be ion-implanted and the ions which should be implanted into the substrate are given, the decrease in the ion implanting energy causes a decrease in both $R_p$ and $\sigma$, reducing the effective channel layer thickness $d$. The decrease in the ion implanting energy is, however, limited by the capability of the ion implantation apparatus along with the increasing sputtering effects and causes problems such as decreases in the controllability and in the uniformity of the ion implantation and a decrease in the carrier mobility.

Further, conventional ion implantation techniques and the subsequent heat treatment for activating the ions result in problems such as the dispersion of the threshold voltage. Ion implantation into a bare compound semiconductor substrate may enhance dissociation of the components and oxidation at the surface of the substrate. Ion implantation through an insulating layer into a compound semiconductor substrate causes the incorporation of the element atoms of the insulating layer into the compound semiconductor substrate, which may have an adverse effect on the compound semiconductor. Heat treatment after ion implantation to activate the implanted ions may cause strains in the substrate due to the difference in the heat expansion coefficients of the substrate and surface protective layers. These result in defects and nonuniform carrier distribution of a channel layer formed in the compound semiconductor substrate, causing nonuniform distribution of the threshold voltages of the FET's across a wafer. Decreasing the standard deviation of the threshold voltage is necessary in order to increase the degree of integration of the LSI's.

One of the inventors of the present invention has already proposed the use of an aluminum nitride (AlN) layer as a protective film for both the ion-implantation and the subsequent heat treatment. In the proposed method, the ions are implanted through the aluminum nitride layer. However, the trend is to use a thinner aluminum nitride layer as a protective film for the ion implantation and, therefore, threshold voltages may vary at different portions of a wafer. The deviation of the threshold voltages of FET's, $\Delta V_{th}$, is an important problem in fabricating GaAs LSI's. At present, when 1k-bit LSI's are fabricated, $\Delta V_{th}$ is allowed up to approximately 60 mV, which can be attained by the prior art, though the yield of the LSI's is low. However, when 4k to 64k-bit LSI's are to be fabricated, $\Delta V_{th}$ should be decreased, for example in the range of approximately 50 to 20 mV, which cannot be attained by the prior art as mentioned above.

A process for fabricating a FET in a GaAs substrate by implanting through a silicon nitride layer and annealing with said layer is known from the communication of B. M. Welch et al, International Electron Devices Meeting, December 1—5, 1979, pages 493—496

AlN capped annealing of Si implanted semi-insulating GaAs is known from Applied Physics Letters, Vol. 40, 15 April 1982, pages 689—690.

It is therefore an object of the present invention to provide a compound semiconductor FET having an improved transconductance.

Another object of the present invention is to improve the ion implantation and the following heat treatment, so as to provide a process for fabricating FET's having an improved uniformity of the threshold voltages.

According to the invention, a process for fabricating an FET comprising a source, a drain, and a control gate in and on a compound semiconductor substrate is defined in claim 1.

By use of such a process, an FET can be achieved with an excellent channel layer thinner than that obtainable in the conventional process.

In a process of fabricating an FET according to the present invention, an AlN layer is used as an insulating layer on a GaAs substrate through which ion implantation is performed into the substrate. This AlN layer can prevent adverse effects in the ion implantation and in the heat treatment on the channel layer, as the AlN is the same III—V group compound as GaAs and therefore recoil implantation is not a serious problem, and has a coefficient of linear expansion approximately equal to that of the GaAs which is effective for minimising the thermal stress from the cap to the crystal. FET's fabricated by using an AlN layer have a small standard deviation of the threshold voltages, improving the throughput of the products, particularly when the degree of integration is increased.

Further the AlN layer used for through-ion-implantation is covered with another insulating layer such as AlN, or $SiO_2$, $Si_3N_4$, $Al_2O_3$, or the like, before performing the heat treatment for activation, when the thickness of the AlN layer for through-ion-implantation becomes thinner in order to increase the transconductance of the FET. This is because a too-thin AlN layer will lose much of its property as an excellent surface protective layer during the heat treatment for ion activation. It has been found that another insulating layer may, however, be formed of a material other than AlN, such as $SiO_2$ or $Si_3N_4$.

Embodiments of the invention will now be described, by way of example, with reference to the drawings, in which:

Figs. 1 to 7 are sectional views showing stages in the fabrication of an FET,

Fig. 8 is a graph of carrier concentration against depth; and

Fig. 9 is a graph of the standard deviation of the threshold voltage against threshold voltage.

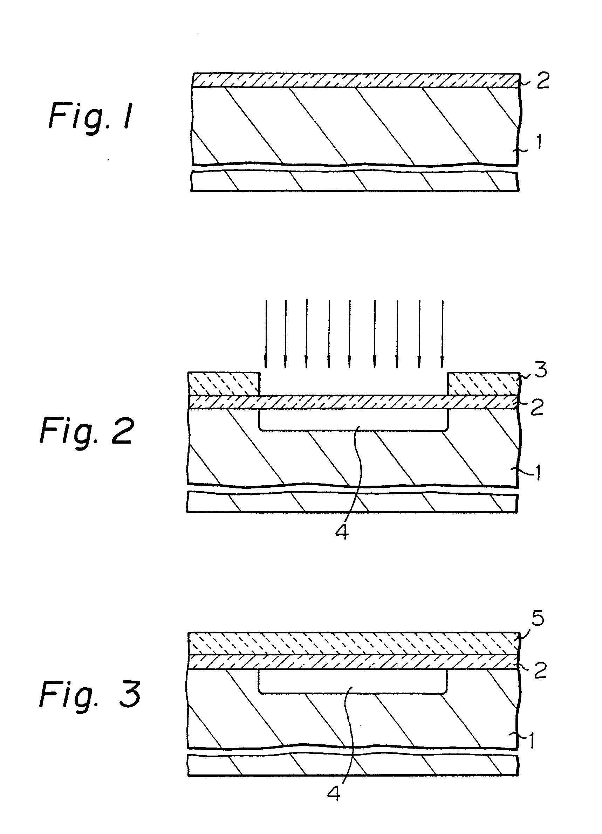

Figs. 1 to 7 illustrate a process for fabricating an FET according to the present invention. In this example, semiconductor devices were fabricated each involving 100 GaAs depletion mode Schottky type FET's. Only one such FET is illustrated in the Figures.

Referring to Fig. 1, on a semi-insulating GaAs single crystal substrate 1 containing approximately 0.8 wt ppm chromium, a first AlN layer 2 is deposited to a thickness of approximately 55 nm by a reactive sputtering technique. This first AlN layer 2 is preferably of a thickness that will not necessitate high energy ion implantation, which will result in a large deviation of the projected range, enlarging the effective channel layer thickness, and, therefore, decreasing the effect of improving the transconductance. The thickness of the first AlN layer 2 is generally in the range below 100 nm, preferably less, in this embodiment it is 55 nm.

In Fig. 2, a mask 3, e.g., silicon dioxide, 800 nm thick is placed covering the first AlN layer 2 and is selectively etched to open a window where a channel layer 4 is to be formed. Silicon ions are implanted at an acceleration energy of 59 keV and a dosage of $4 \times 10^{12}$ cm$^{-2}$ by using the mask 3, and through the first AlN layer 2 in the window into the channel layer 4 in the substrate 1. The acceleration energy and dosage were selected to obtain a distribution of ions in the channel layer 4 after heat treatment, with the maximum concentration at the top surface of the substrate 1, i.e., at the interface of the substrate 1 and the first AlN layer 2, when the first AlN layer 2 has a thickness of 55 nm. The acceleration energy and dosage depend on the kind and the thickness of the insulating layer and on the desired threshold voltages.

In Fig. 3, the mask 3 is removed and a second AlN layer 5 approximately 80 nm thick is then deposited onto the first AlN layer 2, by a reactive sputtering technique. The implanted silicon ions are then activated by heat treatment at a temperature of approximately 800°C for a period of approximately 20 minutes. The characteristics of the thus ion-implanted GaAs substrate and the FET's fabricated therefrom will be described below in more detail.

Conventional processes may be used after the heat treatment, one of which is described below as an example.

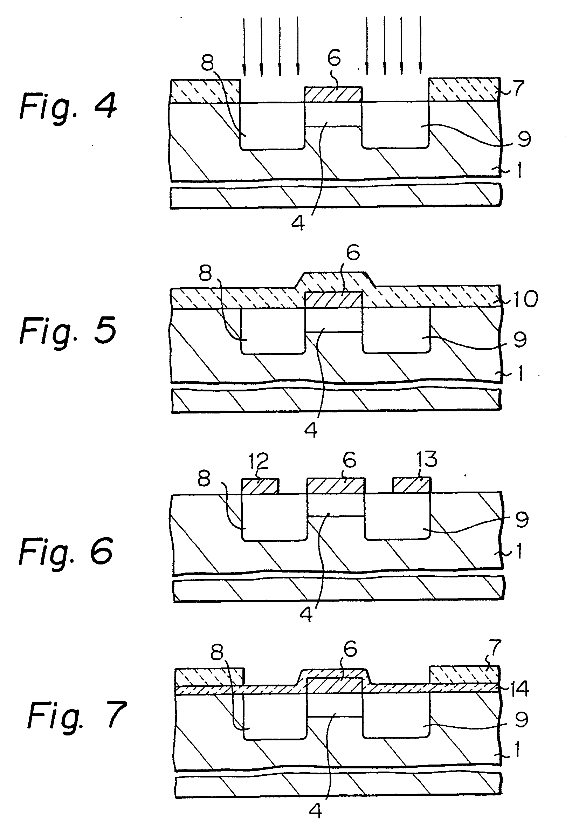

In Fig. 4, the first and second AlN layers 2 and 5 are removed. A metal layer of, e.g., tungsten silicide ($W_5Si_3$), one of the materials that keep their Schottky contact with the GaAs substrate 1 even after a high temperature heat treatment to activate the implanted ions, is deposited over the entire surface to a thickness of approximately 500 nm, and is then patterned to form a control gate 6. A silicon dioxide layer 7 approximately 500 nm is then deposited and patterned to open a window corresponding to the source and drain regions 8 and 9. This silicon dioxide layer 7 is a mask for the following ion implantation and may be replaced by the before-mentioned silicon dioxide mask 3. Ion implantation of the silicon ions is performed at 175 keV and $1.7 \times 10^{13}$ cm$^{-2}$. In this ion implantation, the control gate 6 and the silicon dioxide layer 7 act as masks, and silicon ions are implanted to form a source region 8 and a drain region 9.

In Fig. 5, the silicon dioxide layer 7 is removed and another silicon dioxide layer 10 approximately 150 nm is deposited over the entire surface, as a protective layer for the heat treatment. Preferably, this protective layer may be of AlN. Heat treatment is effected at approximately 800°C for approximately 10 minutes, resulting in an $n^+$-type source 8 and an $n^+$-type drain 9.

In Fig. 6, the silicon dioxide layer 10 is removed. Gold germanium/gold layers are deposited by vapor evaporation, patterend by a lift-off technique, and alloyed at 450°C for 2 minutes to form a source electrode 12 and a drain electrode 13, thus completing the FET.

Selectively, in the above-described example, a further AlN layer 14 may be used for a protective layer through which ion implantation is performed, as shown in Fig. 7.

The FET's fabricated by the above-described process had transconductances of 270 mS/mm at a threshold voltage of 0.02 V and 300 mS/mm at a threshold voltage of −0.04 V, with a gate length of 1 μm. These transconductances are approximately 1.6 times those of FET's which have a Gaussian carrier concentration distribution. The standard deviation of the threshold voltages of the FET's according to the present invention was 44 meV when measured at about 100 points on the entire surface of a 2 inch-diameter wafer.

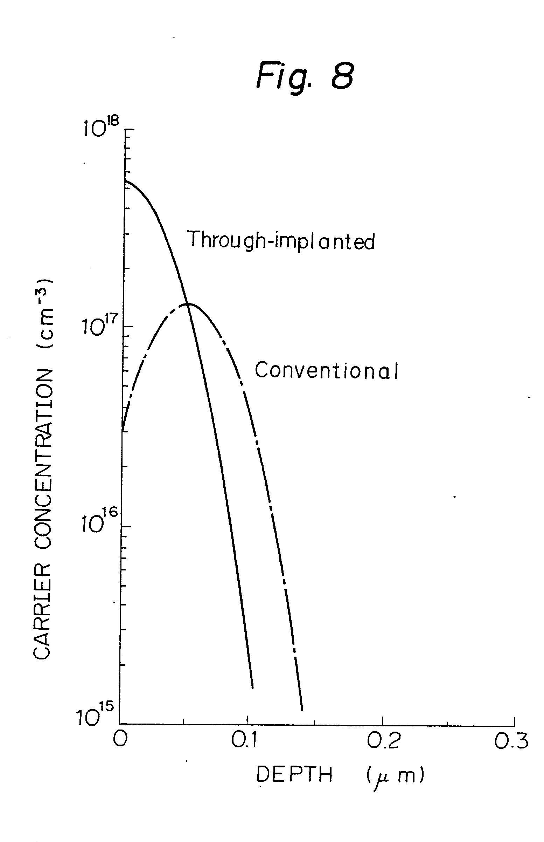

Figure 8 is a graph showing the silicon ion concentration, i.e., carrier concentration in the direction of the depth of the channel layer. The solid line in the figure is obtained by the above-described process, and shows the maximum concentration at depth=0, i.e., at the top surface of the channel layer, and monotonously decreases as the depth increases. The dotted line in the figure is obtained by ion implantation without passivating the AlN layer and has the same threshold voltage as that of the FET of the solid line. The difference in the maximum concentrations of these two cases is needed to obtain the same threshold voltage. As seen from the graph, the depth of the channel layer can be thinner in an FET according to the present invention than in a conventional FET. This thinner depth of the channel layer improves the transconductance of the FET.

In the present invention, low dispersion of the threshold voltages of the FET's also results from the through ion-implantation and heat treatment of a GaAs substrate covered by an AlN layer and another insulating layer thereon.

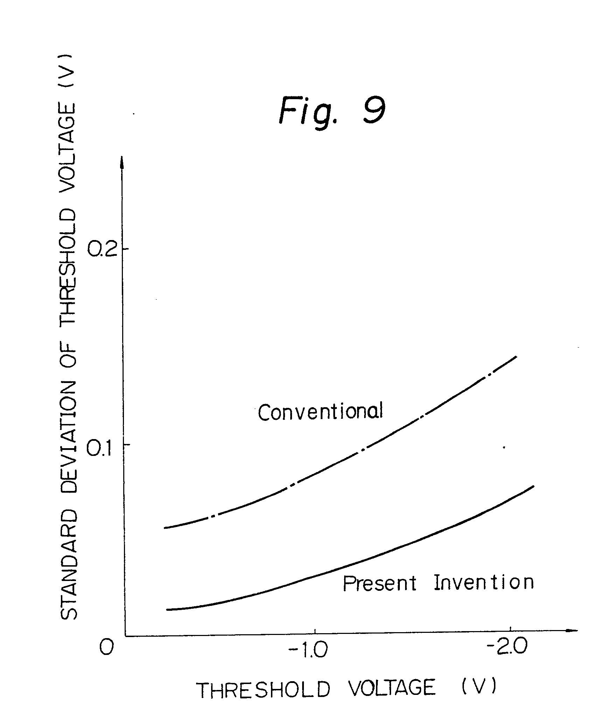

Figure 9 illustrates the standard deviation of the threshold voltage in relation to the threshold voltage determined on the basis of long gate FET's fabricated by a process according to the present invention and by a conventional process. The said line represents an FET according to the present invention, and the dotted line an FET obtained by a conventional process. The graph in Fig. 9 clearly shows that the standard deviation of the threshold voltage in an FET according to the present invention is approximately one-third to one-half that of conventional FET's. For example, a threshold voltage of 0.5 V is obtained with the standard deviation of the threshold voltage of 16 mV. This is a result of using the process comprising the steps of forming an AlN layer on a GaAs substrate, selectively ion implanting to form a channel layer, depositing another insulating layer on the AlN layer, and heat treating for activation, and allows the fabrication of LSI's of a higher degree of integration of 64k-bit or above. In this regard, it should be noted that although an AlN layer was used as the other insulating layer in the before-described example, it has been confirmed that another insulating layer such as $SiO_2$ or $Si_3N_4$ may give the same effect.

An FET according to the present invention preferably has a maximum concentration of silicon ions at the top surface of the channel layer of from $1\times10^{17}$ cm$^{-3}$ to $4\times10^{18}$ cm$^{-3}$. In the fabrication of an FET according to the present invention, ion implantation of silicon through an AlN layer 20 to 100 nm thick, preferably 55 nm thick may be performed at 20 to 100 keV, preferably 59 keV and $1\times10^{12}$ to $4\times10^{13}$ cm$^{-2}$, and heat treatment for activating the silicon ions may be effected at 700—1000°C, preferably 850°C for 1 to 300 minutes, preferably 20 minutes.

## Claims

1. A process for fabricating an FET comprising a source (8), a drain (9), and a control gate (6) in and on a compound semiconductor substrate (1),
   comprising the steps of:
   forming an aluminium nitride layer (2) on and in contact with a surface of the compound semiconductor substrate;
   ion implanting through the aluminium nitride layer (2) into a layer in the compound semiconductor substrate adjacent to the surface;
   forming a second insulating layer (5) on the aluminium nitride layer; and,
   heat treating the ion-implanted compound semiconductor substrate with the aluminium nitride layer and the second insulating layer thereon to activate the implanted ion and form a channel layer (4);
   wherein the conditions of the formation of the aluminium nitride and second insulating layers, ion implantation, and heat treatment are controlled so that the concentration of ions in the channel layer (4) has a maximum value at the surface and the value monotonically decreases from the surface towards the inside of the channel layer.

2. A process according to Claim 1, characterised in that the compound semiconductor substrate (1) is of gallium arsenide.

3. A process according to Claim 1 or 2, characterised in that, in the step of ion implantation, silicon ions are implanted.

4. A process according to any one of Claims 1 to 3, characterised in that the aluminium nitride layer (2) has a thickness from 20 to 200 nm; in that in the step of ion implantation, silicon ions are implanted at 20 to 100 keV and $1\times10^{12}$ to $4\times10^{13}$ cm$^{-2}$; and in the step of heat treatment, the temperature is held at 700°C to 1000°C for 1 to 300 minutes.

5. A process according to Claim 4, characterised in that the aluminium nitride layer (2) is 55 nm thick; in the step of ion implantation silicon ions are implanted at 59 keV and $4\times10^{12}$ cm$^{-2}$; and in the step of heat treatment, the temperature is held at 850° for 20 minutes.

6. A process according to Claim 4, characterised in that the aluminium nitride layer (2) is 30 nm thick; in the step of ion implantation, silicon ions are implanted at 32 keV and $6\times10^{12}$ cm$^{-2}$; and in the step of heat treatment, the temperature is held at 850° for 20 minutes.

7. A process according to any one of Claims 1 to 3 characterised in that the second insulating layer (5) is an aluminium nitride layer.

8. A process according to any one of Claims 1 to 6 characterised in that the second insulating layer (5) is $SiO_2$, $Si_3N_4$ or $Al_2O_3$.

## Patentansprüche

1. Verfahren zur Herstellung eines FET mit einer Source (8), einem Drain (9) und einem Steuergate (6) in und auf einem Verbindungshalbleitersubstrat (1),

mit den folgenden Schritten:

Bilden einer Aluminiumnitridschicht (2) auf und in Kontakt mit einer Oberfläche des Verbindungshalbleitersubstrats;

Ionenimplantierung durch die Aluminiumnitridschicht (2) in eine Schicht neben der Oberfläche in dem Verbindungshalbleitersubstrat;

Bilden einer zweiten isolierenden Schicht (5) auf der Aluminiumnitridschicht; und

Wärmebehandlung des ionenimplantierten Verbindungshalbleitersubstrates mit der Aluminiumnitridschicht und der zweiten isolierenden Schicht darauf, um die implantierten Ionen zu aktivieren und eine Kanalschicht (4) zu bilden;

bei dem die Bedingungen der Bildung der Aluminiumnitridschicht und der zweiten isolierenden Schichten, der Ionenimplantation und der Wärmebehandlung so gesteuert werden, daß die Konzentration der Ionen in der Kanalschicht (4) einen Maximalwert an der Oberfläche hat und der Wert von der Oberfläche zu der Innenseite der Kanalschicht monoton abnimmt.

2. Verfahren nach Anspruch 1, dadurch gekennzeichnet, daß das Verbindungshalbleitersubstrat (1) aus Galliumarsenid besteht.

3. Verfahren nach Anspruch 1 oder 2, dadurch gekennzeichnet, daß bei dem Schritt der Ionenimplantation Siliciumionen implantiert werden.

4. Verfahren nach einem der Ansprüche 1 bis 3, dadurch gekennzeichnet, daß die Aluminiumnitridschicht (2) eine Dicke von 20 bis 200 nm hat; daß bei dem Schritt der Ionenimplantation Siliciumionen bei 20 bis 100 keV und $1\times10^{12}$ bis $4\times10^{13}cm^{-2}$ implantiert werden; und bei dem Schritt der Wärmebehandlung die Temperatur 1 bis 300 Minuten lang bei 700°C bis 1000°C gehalten wird.

5. Verfahren nach Anspruch 4, dadurch gekennzeichnet, daß die Aluminiumnitridschicht (2) 55 nm dick ist; bei dem Schritt der Ionenimplantation Siliciumionen bei 59 keV und $4\times10^{12}cm^{-2}$ implantiert werden; und bei dem Schritt der Wärmebehandlung die Temperatur 20 Minuten lang bei 850° gehalten wird.

6. Verfahren nach Anspruch 4, dadurch gekennzeichnet, daß die Aluminiumnitridschicht (2) 30 nm dick ist; bei dem Schritt der Ionenimplantation Siliciumionen bei 32 keV und $6\times10^{12}cm^{-2}$ implantiert werden; und bei dem Schritt der Wärmebehandlung die Temperatur 20 Minuten lang bei 850° gehalten wird.

7. Verfahren nach einem der Ansprüche 1 bis 3, dadurch gekennzeichnet, daß die zweite isolierende Schicht (5) eine Aluminiumnitridschicht ist.

8. Verfahren nach einem der Ansprüche 1 bis 6, dadurch gekennzeichnet, daß die zweite isolierende Schicht (5) $SiO_2$, $Si_3N_4$ oder $Al_2O_3$ ist.

## Revendications

1. Procédé de fabrication d'un FET, comprenant une source (8), un drain (9) et une grille de commande (6), dans et sur un substrat de semiconducteur composé (1),

comprenant les opérations suivantes:

former une couche de nitrure d'aluminium (2) sur une surface du substrat de semiconducteur composé et en contact avec cette surface;

implanter des ions au travers de la couche de nitrure d'aluminium (2) dans une couche du substrat de semiconducteur composé qui est adjacente à la surface;

former une deuxième couche isolante (5) sur la couche de nitrure d'aluminium; et

appliquer un traitement thermique au substrat de semiconducteur composé qui à subi l'implantation ionique et est doté de la couche de nitrure d'aluminium et de la deuxième couche isolante, afin d'activer les ions implantés et de former une couche de canal (4);

où les conditions de formation de la couche de nitrure d'aluminium et de la deuxième couche isolante, de l'implantation ionique et du traitement thermique sont ajustées de façon que la concentration en ions dans la couche de canal (4) possède une valeur maximale au niveau de la surface et que sa valeur diminue de manière monotone de la surface vers l'intérieur de la couche de canal.

2. Procédé selon la revendication 1, caractérisé en ce que le substrat de semiconducteur composé (1) est fait d'arséniure ds gallium.

3. Procédé selon la revendication 1 ou 2, caractérisé en ce que, dans l'opération d'implantation ionique, on implante des ions de silicium.

4. Procédé selon l'une quelconque des revendications 1 à 3, caractérisé en ce que la couche de nitrure d'aluminium (2) possède une épaisseur de 20 à 200 nm; en ce que, dans l'opération d'implantation ionique, on implante des ions de silicium avec une énergie de 20 à 100 keV et une dose de $1\times10^{12}$ à $4\times10^{13}cm^{-2}$; et en ce que, dans l'opération de traitement thermique, on maintient la température à une valeur de 700°C à 1 000°C pendant une durée de 1 à 300 min.

5. Procédé selon la revendication 4, caractérisé en ce que la couche de nitrure d'aluminium (2) a une épaisseur de 55 nm; en ce que, dans l'opération d'implantation ionique, on implante des ions de silicium à 59 keV et $4\times10^{12}cm^{-2}$; et en ce que, dans l'opération de traitement thermique, on maintient la température à 850°C pendant 20 min.

6. Procédé selon la revendication 4, caractérisé en ce que la couche de nitrure d'aluminium (2) a une épaisseur de 30 nm; en ce que, dans l'opération d'implantation ionique, on implante des ions de silicium à 32 keV et $6\times10^{12}cm^{-2}$; et en ce que, dans l'opération de traitement thermique, on maintient la température à 850°C pendant 20 min.

7. Procédé selon l'une quelconque des revendications 1 à 3, caractérisé en ce que la deuxième couche isolante (5) est une couche de nitrure d'aluminium.

8. Procédé selon l'une quelconque des revendications 1 à 6, caractérisé en ce que la deuxième couche isolante (5) est faite de SiO$_2$, Si$_3$N$_4$ ou Al$_2$O$_3$.

EP 0 112 657 B1

Fig. 1

Fig. 2

Fig. 3

1

Fig. 4

Fig. 5

Fig. 6

Fig. 7

## Fig. 8

Fig. 9